(19) Europäisches Patentamt
European Patent Office
Office européen des brevets

(11) EP 2 820 437 B1

(12) **EUROPÄISCHE PATENTSCHRIFT**

(45) Veröffentlichungstag und Bekanntmachung des Hinweises auf die Patenterteilung:
**20.11.2019 Patentblatt 2019/47**

(21) Anmeldenummer: **13711580.4**

(22) Anmeldetag: **27.02.2013**

(51) Int Cl.:
***G06F 17/14*** (2006.01) ***G01R 31/08*** (2006.01)
***G01R 21/06*** (2006.01) *G01R 19/25* (2006.01)
*G01R 27/16* (2006.01)

(86) Internationale Anmeldenummer:
**PCT/EP2013/053937**

(87) Internationale Veröffentlichungsnummer:
**WO 2013/127856 (06.09.2013 Gazette 2013/36)**

(54) **VERFAHREN ZUM ERMITTELN EINER BEZIEHUNG ZWISCHEN ZWEI SICH SINUSPERIODISCH ÄNDERNDEN GRÖSSEN UND DIAGNOSEGERÄT**

METHOD FOR DETERMINING A RELATIONSHIP BETWEEN TWO SINUSOIDALLY PERIODICALLY VARYING VARIABLES AND DIAGNOSIS DEVICE

PROCÉDÉ POUR DÉTERMINER UNE RELATION ENTRE DEUX GRANDEURS QUI VARIENT DE MANIÈRE PÉRIODIQUE SINUSOÏDALE ET APPAREIL DE DIAGNOSTIC

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.02.2012 DE 102012004723**

(43) Veröffentlichungstag der Anmeldung:
**07.01.2015 Patentblatt 2015/02**

(73) Patentinhaber:
- **MDN Main-Donau Netzgesellschaft mbH 90441 Nürnberg (DE)**
- **Friedrich-Alexander-Universität Erlangen-Nürnberg 91054 Erlangen (DE)**

(72) Erfinder:
- **WEINDL, Christian 90513 Zirndorf (DE)**
- **FREITAG, Christian 95490 Mistelgau (DE)**
- **MLADENOVIC, Ivana 90556 Seukendorf (DE)**
- **HEROLD, Gerhard 06406 Bernburg (Saale) (DE)**

(74) Vertreter: **Louis Pöhlau Lohrentz Patentanwälte Postfach 30 55 90014 Nürnberg (DE)**

(56) Entgegenhaltungen:
**US-A1- 2005 218 907**

- **Freitag F et al: "Fully automated MV cable monitoring and measurement system for multi-sample acquisition of artificial aging parameters", International Conference on Renewable Energies and Power Quality (ICREPQ'10), 23-25 March 2010, Granada, Spain, 23. März 2010 (2010-03-23), XP055100065, Gefunden im Internet: URL:http://icrepq.com/icrepq'10/437-Freita g.pdf [gefunden am 2014-02-04] in der Anmeldung erwähnt**
- **SZYPER M ET AL: "Spectral analysis of nonstationary signals in the system with wide phase modulation", PROCEEDINGS OF THE INSTRUMENTATION AND MEASUREMENT TECHNOLOGY CONFERENCE 1992, 12-14 MAY 1992, NEW YORK, USA, 12. Mai 1992 (1992-05-12), Seiten 42-45, XP010063963, DOI: 10.1109/IMTC.1992.245180 ISBN: 978-0-7803-0640-0**
- **ZIELINSKI T P: "Instantaneous phase shift estimation methods", PROCEEDINGS OF THE INSTRUMENTATION AND MEASUREMENT TECHNOLOGY CONFERENCE 1996, 4-6 JUNE 1996, BELGIUM, Bd. 1, 4. Juni 1996 (1996-06-04), Seiten 162-167, XP010163864, DOI: 10.1109/IMTC.1996.507368 ISBN: 978-0-7803-3312-3**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 820 437 B1

- MASKELL D L ET AL: "The discrete-time quadrature subsample estimation of delay", IEEE TRANSACTIONS ON INSTRUMENTATION AND MEASUREMENT, Bd. 51, Nr. 1, Februar 2002 (2002-02), XP011025487, ISSN: 0018-9456
- ZHENGKAO ZHANG ET AL: "Some aspects or a digital method for the measurement of loss factor of high voltage insulation", 1997 IEEE ANNUAL REPORT, CONFERENCE ON ELECTRICAL INSULATION AND DIELECTRIC PHENOMENA, 19-22 OCTOBER 1997, MINNEAPOLIS, MN, USA, 19. Oktober 1997 (1997-10-19), Seiten 279-282, XP010255812, DOI: 10.1109/CEIDP.1997.634613 ISBN: 978-0-7803-3851-7

**Beschreibung**

Die Erfindung betrifft ein Verfahren zum Ermitteln einer Beziehung zwischen zwei sich im Wesentlichen gemäß einer Sinuskurve periodisch ändernden Größen. Sie betrifft auch ein Diagnosegerät zur Durchführung des Verfahrens.

Die Motivation zur Bereitstellung des Verfahrens stammt aus dem Gebiet der Vermessung von Mittel- oder Hochspannungskabeln, die unterboden-verlegt sind, also Erdkabeln. Hier gilt es zu bestimmen, ob die Kabel einen Alterungsprozess durchlaufen haben und daher auszutauschen sind. Eine wesentliche Größe ist hierbei der Verlustfaktor, den man mit tan $\delta$ bezeichnet. Für diese Winkelgröße $\delta$ gilt $\delta = \pi/2 - \varphi$, wobei $\varphi$ der Phasenwinkel bzw. die Phasendifferenz zwischen einer an dem Kabel anliegenden Wechselspannung und dem dadurch erzeugten Wechselstrom durch die Isolation ist. Die Wechselspannung in Form einer Sinuskurve liegt hierbei zwischen dem Innenleiter und dem Außenleiter bzw. dem Schirm oder aber zwischen mehreren Innenleitern des Kabels und gegebenenfalls dem Schirm an. Üblicherweise ist der Außenleiter (Mantel) mit Masse (Erde) gekoppelt. Es stellt nun eine Aufgabe dar, auch in realen Situationen, in denen die Wechselspannung und der Wechselstrom nicht ideal sinusförmig periodisch sind, eine entsprechende Beziehung zwischen den beiden vorliegenden elektrischen Größen abzuleiten.

Ein erster Ansatzpunkt, wie die Beziehung zwischen zwei sich im Wesentlichen gemäß einer Sinuskurve periodisch ändernden Größen ermittelt werden kann, findet sich in dem Beitrag von C. Freitag, I. Mladenovic und C. Weindl mit dem Titel "Fully Automated MV Cable Monitoring and Measurement System for Multi-Sample Acquisition of Artificial Aging Parameters" zur "International Conference on Renewable Energies and Power Quality (ICREPQ'10)", Granada/Spanien, die vom 23. bis zum 25. März 2010 stattfand. In diesem Beitrag wird das Konzept vorgestellt, dass die erste, sich gemäß der Sinuskurve periodisch ändernde Größe, zu einer Mehrzahl von Zeitpunkten $t_k$, k = 1,..., N, insbesondere über zumindest eine Periode hinweg, gemessen wird, und dass auch die zweite Größe zu denselben Zeitpunkten $t_k$ gemessen wird. Jedem der Zeitpunkte $t_k$ wird nun ein virtueller Imaginärteil zugeordnet, in dem ein in der Periode um 90 ° ($\pi/2$) verschobener Messwert verwendet wird. Bei Zutreffen der Annahme, dass eine Sinusform vorliegt, lässt sich mit dem eigentlichen Messwert zu einem bestimmten Zeitpunkt $t_k$ als Realteil und dem hinzugenommenen Imaginärteil ein 2-Tupel bilden, nämlich eine komplexe Zahl.

In dem genannten Beitrag von C. Freitag et al. ist davon ausgegangen, dass jede komplexe Zahl so abzubilden ist, dass die Zeitabhängigkeit mit der als konstant angenommenen Grundfrequenz nicht mehr dargestellt ist. Sie wird daher mit einem Faktor $e^{-j\omega t}$ multipliziert, wobei j die imaginäre Einheit ist, $\omega$ die (angenommene) Frequenz der Sinusschwingung (Netzfrequenz) und t der Zeitpunkt der jeweiligen Messung ist. Dies entspricht dem aus der Raumzeigertheorie bekannten Verfahren der Transformation in ein mit der Netzfrequenz rotierendes Koordinatensystem. Nachteilig hieran ist, dass die Unsicherheiten in der Angabe bzw. Bestimmung der Frequenz sowie jegliche während des Messzeitraums auftretenden Abweichungen bzw. Änderungen der Grundfrequenz sofort zu Messfehlern führen, und es müssen auch die Zeitpunkte der einzelnen Messpunkte präzise bestimmt sein. Bei dem genannten Beitrag von C. Freitag et al. wird nach dem Multiplizieren mit dem genannten Faktor $e^{-j\omega t}$ eine Filterung vorgenommen und sodann ein Zahlenwert ausgerechnet, aus dem auf den Phasenversatz zwischen den beiden Größen geschlossen wird. Die sich durch Änderungen der Grundfrequenz oder abweichende Messzeitpunkte ergebenden Messfehler führen zu systematischen Verschleifungen und Abweichungen der mit den Faktor $e^{-j\omega t}$ multiplizierten komplexen Eingangswerte, so dass die nachfolgende Filterung nicht mehr im Wesentlichen der stochastische Streuung der Eingangssignale (Rauschen, Störsignale, ...) entgegenwirkt, sondern maßgeblich die genannten Abweichungen der Grundfrequenz sowie Abtastzeitpunkte unter einem erheblichen Verlust der Präzision ausmitteln.

Die Veröffentlichung von M.Szyper at al.: "Spectral analysis of nonstationary signals in the system with wide phase modulation" zur "Proceedings of the IEEE Instrumentation and Measurement Technology Conference" (Seiten 42-45), die vom 12. bis zum 14. Mai 1992 in New York stattfand, befasst sich mit einer Phasenmodulation bzw. einer Phasendemodulation von hochfrequenten Signalen.

Es ist Aufgabe der vorliegenden Erfindung, ein verbessertes Verfahren und eine entsprechende Vorrichtung zum Ermitteln einer Beziehung zwischen zwei sich im Wesentlichen gemäß einer Sinuskurve periodisch ändernden Größen anzugeben, das bzw. die eine besonders hohe Präzision bei der Bestimmung dieser Beziehung zeigt.

Die Aufgabe wird durch ein Verfahren gemäß Patentanspruch 1 und eine Vorrichtung gemäß Patentanspruch 10 gelöst.

Ein erster wesentlicher Aspekt der Erfindung besteht darin, dass die komplexen Zahlen $\underline{a}[k]$ und $\underline{b}[k]$ nicht einer zuvorigen Transformation (im Sinne einer Drehung mit dem Faktor $e^{-j\omega t}$) unterzogen werden, bevor die eigentliche Berechnung erfolgt. Auf diese Weise spiegeln die einzelnen Verhältnisgrößen $\underline{c}[k]$ für unterschiedliche k die jeweilige zum Zeitpunkt $t_k$ herrschende absolute Phasenbeziehung der komplexen Zahlen $\underline{a}[k]$ und $\underline{b}[k]$ in deren Sinuskurven wieder. Da Abweichungen in der Grundfrequenz oder nicht zu regulären Zeitpunkten erfasste Messpaare der Grundgrößen in vergleichbarer Weise sowohl in a[k] als auch b[k] eingehen, kann es hierbei zu keinen signifikanten Veränderungen der Phasenbeziehung in $\underline{c}[k]$ kommen. Die Verhältnisgrößen $\underline{c}[k]$ stellen komplexe Zeiger dar, die lediglich wegen stochastischer Einflüsse (Rauschen, Störsignale, Quantisierung der der AD-Umsetzung, ...) in kleinerem Maße von einem komplexen Mittelwertzeiger abweichen. Da Änderungen der Grundfrequenz oder der Abtastzeitpunkte keinen direkten Eingang in die $\underline{c}[k]$ finden, erhöht sich die Präzision der Ergebnisse der nachfolgenden Mittelwertbildung/Filterung ganz erheblich. Zudem kann das beschriebene Verfahren bereits nach einer viertel Periode der Grundschwingung ein Ergebnis liefern, was einen entscheidenden Vorteil gegenüber der Transformation darstellt. Der erzielte Mittelwert $\underline{c}$ erlaubt daher eine gute Aussage über den tatsächlichen Wert einiger Beziehungsgrößen gerade auch bei der in der Praxis in der Regel anzutreffenden veränderlichen Grundfrequenz oder Abweichungen der Erfassungszeitpunkte.

Wie eingangs ausgeführt, sind die beiden Größen elektrische Größen, nämlich Spannung und Stromstärke.

Hierbei ist die eine Größe eine an einem (Erd-) Kabel, insbesondere Mittel- oder Hochspannungskabel anliegende Spannung und die andere Größe eine Stromstärke eines durch die Isolation des Kabels fließenden Stroms.

Die in den Schritten des Messens der ersten und zweiten Größe gewonnenen Messwerte werden bevorzugt einer Recheneinrichtung zugeführt, gegebenenfalls unter Transformation ihrer Amplitude, damit sie als Kleinsignale vorliegen (zwischen 0 und 12 V oder zwischen 0 und 5 V o. ä.).

Eine Recheneinrichtung kann solche Kleinsignale effektiv verarbeiten, sodass die nachfolgenden Bearbeitungsschritte digital durchgeführt werden können.

Bevorzugt verknüpft hierbei die Recheneinrichtung zum Bilden eines 2-Tupels für eine Größe jeweils einen ersten Speicherplatz für einen Messwert für die Größe mit einem zweiten Speicherplatz für einen anderen Messwert für die Größe.

Dieses Verknüpfen kann beispielsweise mit Hilfe eines Zeigers (Pointers) geschehen, sodass die 2-Tupel nicht gesondert zusätzlich zu den Messwerten abgespeichert werden müssen.

Bei einer bevorzugten Ausführungsform der Erfindung werden im Schritt des Bildens der Verhältnisgröße Rechenschritte für eine Division komplexer Zahlen durchgeführt, wobei der jeweilige Messwert aus dem ersten Speicherplatz als Realteil und der jeweilige Messwert aus dem zweiten Speicherplatz als Imaginärteil interpretiert werden, sodass man als Verhältnisgröße wieder ein 2-Tupel erhält. Hierdurch ist gewährleistet, dass tatsächlich aus den Verhältnisgrößen c[k] bzw. ihrem Mittelwert c zuverlässige Aussagen abgeleitet werden können.

Weiter bevorzugt ist vorgesehen, dass im Schritt des Berechnen des Mittelwerts die 2-Tupel der Verhältnisgröße unter Verwendung der Rechenschritte einer Addition komplexer Zahlen zu einem neuen 2-Tupel verknüpft werden, wobei für die Addition der erste Eintrag der 2-Tupel als Realteil und der zweite Eintrag der 2-Tupel als Imaginärteil interpretiert werden.

Im Endschritt des Verfahrens wird aus dem 2-Tupel $\underline{c}$, das den Mittelwert beschreibt, die Phase $\varphi = \arg c$ (als Argument von $\underline{c}$) und der Betrag $|\underline{c}|$ berechnet, wobei der erste Eintrag des 2-Tupels für den Mittelwert als Realteil und der zweite Eintrag des 2-Tupels für den Mittelwert als Imaginärteil interpretiert werden, und wobei $\varphi$ und $|\underline{c}|$ als Aussage für die Beziehung der Größe verwendet werden.

Die Größen $\varphi$ und $|\underline{c}|$ sind zwei sehr aussagekräftige Größen, aus denen auch noch weitere Aussagen abgeleitet werden können. So wird bevorzugt auch aus zumindest einem von $\varphi$ und $|\underline{c}|$ eine weitere Größe berechnet, insbesondere der Verlustfaktor tan $(\pi/2 - \varphi)$, eine Impedanz, Admittanz, Resistanz, Konduktanz, der Leistungsfaktor cos $\varphi$, eine Dielektrizitätskonstante des Kabels, eine Scheinleistung, Wirkleistung und/oder Blindleistung berechnet wird. Dies sind diejenigen Größen, mit denen sich Aussagen erschließen lassen, ob das untersuchte Kabel funktionsfähig ist oder nicht und entsprechend im Boden verbleiben kann oder ausgetauscht werden muss.

Bei einer bevorzugten Ausgestaltung der Erfindung in allen genannten Ausführungsformen ist der Mittelwert der arithmetische Mittelwert, sodass gilt:

$$\underline{c} = \frac{1}{N} \sum_{k=1}^{N} \underline{c}[k]$$

Der arithmetische Mittelwert eignet sich insbesondere bei statistisch verteilten Störeinflüssen zur Elimination derselben.

Erfindungsgemäß wird für das 2-Tupel für einen Zeitpunkt $t_k$ jeweils ein Messwert zum Zeitpunkt $t_k$ verwendet und ein Messwert zu einem Zeitpunkt $t_{k'}$ verwendet, wobei der Zeitpunkt $t_{k'}$ um $\frac{1}{4} \pm n, n \in \mathbb{Z}$ Periodendauern T der Sinuskurve zeitlich vom Zeitpunkt $t_k$ beabstandet ist. Dass der Zeitpunkt $t_{k'}$ um $\frac{1}{4} \pm n$ Periodendauern T zeitlich beabstandet ist, lässt sich alternativ auch so ausdrücken, dass der Zeitpunkt $t_{k'}$ um $\frac{3}{4} \pm n$ Periodendauern T der Sinuskurve zeitlich vom Zeitpunkt $t_k$ beabstandet ist.

Auf diese Weise erhält man eine besonders präzise komplexe Zahl, die die Sinusschwingung besonders gut beschreibt.

Die Aufgabe wird in einem anderen Aspekt der Erfindung auch durch ein Diagnosegerät mit den Merkmalen des Patentanspruchs 10 gelöst.

Das Diagnosegerät zum Ermitteln einer Beziehung zwischen einer Spannung und einer Stromstärke, insbesondere in einem Mittel- oder Hochspannungskabel, weist somit eine Einrichtung zum Messen von N Werten der Spannung und eine Einrichtung zum Messen von N Werten der Stromstärke auf. Solche Messeinrichtungen sind an sich bekannt. Beispielsweise umfasst eine Einrichtung zum Messen der Spannung einen Spannungsteiler mit einem Impedanzelement, z. B. einem Widerstand, und eine Messeinrichtung zum Messen der an diesem Impedanzelement abfallenden Spannung. Diese Messung kann zunächst analog erfolgen und sodann in digitale Werte übersetzt werden oder unmittelbar durch digitale Abtastung ermittelt werden. Genauso umfasst die Einrichtung zum Messen von N Werten der Stromstärke bevorzugt einen Shunt-Widerstand, über den der Strom, dessen Stromstärke zu messen ist, geführt wird, und eine über diesem Shunt-Widerstand abfallende Spannung wird mit einem geeigneten Spannungsmessgerät gemessen, das entweder analog arbeitet und dann die analogen Werte in digitale Messwerte wandelt, oder unmittelbar digital arbeitet.

Das erfindungsgemäße Diagnosegerät weist ferner eine Recheneinrichtung auf, die ausgelegt ist, die erhaltenen N digitalen Werte für die Spannung und die N digitalen Werte für die Stromstärke durch digitale Datenverarbeitung weiterzuverarbeiten. In der Regel wird die Recheneinrichtung eine digitale Datenverarbeitungseinrichtung sein, die geeignet programmiert ist. Dies bedeutet, dass ihr ein Programmcode zugeordnet ist, welcher beispielsweise auf einer geeigneten Speichereinrichtung der Recheneinrichtung abgelegt ist und zum Ablauf bringbar ist (z. B. auf einem Arbeitsspeicher der Recheneinrichtung). Die digitalen Verarbeitungsschritte sollen die bereits zum erfindungsgemäßen Verfahren o.g. Schritte sein (jeweils Bilden eines 2-Tupels für die Spannung und für die Stromstärke, Bilden der Verhältnisgröße für alle k 2-Tupel, unmittelbar Berechnen eines Mittelwerts $\underline{c}$ aus allen Verhältnisgrößen $\underline{c}[k]$ und Ableiten einer Aussage über die Beziehung aus dem Mittelwert $\underline{c}$).

Nachfolgend wird eine bevorzugte Ausführungsform der Erfindung unter Bezug auf die Zeichnung näher beschrieben, in der

- Fig. 1 ein Flussschaubild zur Erläuterung einer Ausführungsform zum erfindungsgemäßen Verfahren ist,
- Fig. 2a einen Messaufbau veranschaulicht, wie er zur Messung von Spannung und Strom über ein Mittel- oder Hochspannungskabel eingesetzt wird, wobei die Messung auf Mittel- bzw. Hochspannungspotenzial erfolgt,
- Fig. 2b einen Messaufbau veranschaulicht, wie er zur Messung von Spannung und Strom über ein Mittel- oder Hochspannungskabel eingesetzt wird, wobei die Messung auf Erdpotenzial erfolgt,
- Fig. 3a zwei Sinuskurven veranschaulicht, anhand derer das Konzept der Bildung eines 2-Tupels beim erfindungsgemäßen Verfahren veranschaulicht wird,
- Fig. 3b eine entsprechende Darstellung einer Kurve in der komplexen Ebene veranschaulicht,
- Fig. 4a eine der Fig. 3b entsprechende Darstellung von mit Rauschen behafteten Messwerten der Spannung und des Stroms zeigt,
- Fig. 4b das Verhältnis von Spannung zu Strom als komplexe Zahl in einer komplexen Ebene für eine Vielzahl von Werten aus Fig. 4a veranschaulicht,
- Fig. 5 eine der Fig. 4b entsprechende Darstellung ist, für den Fall, dass die zugrunde liegende Sinusschwingung verzerrt ist,
- Fig. 6 zur Erläuterung eines Beispiels ein moduliertes Eingangssignal (Strom und Spannung) zeigt, das durch ein Verfahren gemäß dem Stand der Technik einerseits und das erfindungsgemäße Verfahren andererseits ausgewertet wird,
- Fig. 7 eine der Fig. 4a entsprechende Darstellung der Eingangssignale aus Fig. 6 in einer komplexen Ebene veranschaulicht,
- Fig. 8a jeweils ausgehend von der Darstellung nach Fig. 7 das Ergebnis einer Transformation in ein mit der Netzfrequenz rotierendes Koordinatensystem ("ruhender Zeiger") veranschaulicht,
- Fig. 8b einen anhand der Fig. 8a zugrunde liegenden Berechnung erhaltenen Wert, der die Beziehung zwischen Strom und Spannung angibt, zeigt, und
- Fig. 9 eine der Fig. 4b entsprechende Darstellung des Verhältnisses von Spannung zu Strom als komplexe Zahl in einer komplexen Ebene für eine Vielzahl von Werten aus Fig. 7 sowie den hierbei erhaltenen Mittelwert veranschaulicht.

Bei einem Verfahren zum Ermitteln einer Beziehung zwischen zwei sich im Wesentlichen gemäß einer Sinuskurve periodisch ändernden Größen a(t) und b(t) werden zunächst N diskrete Werte a[k] der Größe a(t) und N diskrete Werte b[k] der Größe b(t) erfasst, und zwar zu denselben Zeitpunkten $t_k$, wozu ein Synchronisieren erfolgt. Der Schritt des Erfassens der diskreten Werte a[k] ist der Schritt S10, der des Erfassens der Werte b[k] ist der Schritt S10'.

Im vorliegenden Beispiel werde angenommen, dass ein Prüfling P (Fig. 2a und 2b) ein Erdkabel sei. Ein solches Kabel lässt sich im einfachsten Fall durch seinen Widerstand $R_{Kabel}$ und eine Kapazität $C_{Kabel}$ zwischen dem Innenleiter und dem metallischen Außenleiter beschreiben. Bei einer Alterung des Erdkabels verändern sich der Widerstand und die Kapazität. Dies schlägt sich im sog. Verlustfaktor tan $\delta$ nieder. Soll dieser gemessen werden, so muss eine Prüfspannung $u_p$ (t) angelegt und gemessen werden und zusätzlich die Stromstärke $i_p$ (t) des hierbei fließenden elektrischen Stroms gemessen werden.

Mit Hilfe eines Diagnosegeräts D erfolgt die Messung und Auswertung. Die Spannungsmessung erfolgt über eine Spannungsteilung unter Verwendung einer Teilerkapazität $C_{Teiler}$ und eines Teilerwiderstands $R_{Tener}$, wobei die Messung der Spannung u(t) an dem Teilerwiderstand $R_{Teiler}$ erfolgt. In Reihe zu dem Prüfkabel ist ein Shuntwiderstand $R_{Shunt}$ geschaltet, an dem eine Spannung abfällt, die ein Maß für die Stromstärke i(t) ist. Aus u(t) kann die Prüfspannung $u_p(t)$ abgeleitet werden, aus i(t) kann die Stromstärke $i_p(t)$ berechnet werden.

Fig. 2a zeigt die in der Regel vorgenommene Messung auf Mittel- bzw. Hochspannungspotenzial. Es kann jedoch auch eine Messung auf Erdpotenzial nach Art von Fig. 2b erfolgen.

Eine Prüfspannung $u_p(t)$ hat nun eine ideale Amplitude, wie sie anhand der Kurve 10 in Fig. 3a gezeigt ist. Man kann nun jedem Punkt in dieser Kurve einen um eine Viertel-Periode versetzten Wert gemäß der Kurve 12 zuordnen und diesen zweiten Wert als Imaginärteil interpretieren. Trägt man nun Realteil und Imaginärteil über die Zeit auf, so erhält man gemäß Fig. 3b genau einen Kreis 14. Mit Hilfe eines solchen Kreises bzw. von Messwerten auf einem solchen Kreis lassen sich bestimmte Berechnungen leichter durchführen, wie nachfolgend deutlich wird.

Im Schritt S12 erfolgt also zunächst das Auto-Erweitern der Werte a[k] zu N komplexen Werten $\underline{a}[k]$, wobei für den Realteil gilt:

$$\mathrm{Re}\ \underline{a}[k] = a[k \pm m \times N_p],$$

wobei $N_p$ die Zahl der Abtastwerte pro Periode ist.

Für den Imaginärteil von $\underline{a}[k]$ gilt:

$$\mathrm{Im}\ \underline{a}[k] = a[k-\frac{1}{4} \times N_P \pm n \times N_P].$$

Die Zahlen m und n sind hierbei ganze Zahlen.

Während das Auto-Erweitern der Werte a[k] zum Wert $\underline{a}[k]$ im Schritt S12 erfolgt, erfolgt das entsprechende Auto-Erweitern bei den Werten b[k] zu den komplexen Werten $\underline{b}[k]$ im Schritt S12'.

Nun wird in einem nachfolgenden Schritt S14 für alle N Werte von k die Verhältnisgröße berechnet:

$$\underline{c}[k] = \frac{\underline{a}[k]}{\underline{b}[k]}$$

Die Erfindung liegt darin, dass vorliegend unabhängig vom Zeitpunkt $t_k$ für die Messung des Wertes a[k] und b[k] die Verhältnisgröße $\underline{c}[k]$ gebildet wird. Insbesondere erfolgt nicht eine Abbildung zur Elimination der zeitlichen Abhängigkeit von der Grundfrequenz (Rückdrehung mit Netzfrequenz).

Diese in Schritt S14 durchgeführte Berechnung von N Werten für $\underline{c}[k]$ geht unmittelbar über in den Schritt S16 des Bildens des Mittelwerts, vorliegend des arithmetischen Mittelwerts. Anstelle des arithmetischen Mittelwerts kann auch mit Hilfe einer Filterung ein gewichteter Mittelwert berechnet werden. In Schritt S16 wird somit der Mittelwert

$$\underline{c} = \frac{1}{N} \sum_{k=1}^{N} \underline{c}[k]$$

berechnet.

Aus diesem Mittelwert $\underline{c}$ kann nun die Phase abgeleitet werden, es wird nämlich in Schritt S18 das Argument $\varphi$: = arg ($\underline{c}$) ermittelt. Genauso kann auch in Schritt S20 der Betrag $|\underline{c}|$ berechnet werden. Aus diesen beiden in Schritt S18 und S20 berechneten Größen $\varphi$ und $|\underline{c}|$ können dann weitere Größen berechnet werden, wie beispielsweise der Verlustfaktor tan $\delta$ = tan ($\pi$/2 - $\varphi$), die Wirkleistung, die Blindleistung, die Impedanz u. v. a. m.

Das erfindungsgemäße Verfahren wird im Beispielsfall wie in Fig. 4a gezeigt durchgeführt: Die mit dem Messaufbau gemäß Fig. 2a bzw. 2b ermittelte Spannung U [V] wird zur komplexen Zahl auto-erweitert, sodass man die Kurve 16 erhält, genauso werden die Werte für den Strom komplex auto-erweitert, sodass man die Kurve 18 erhält. Durch Division der Werte aus der Kurve 16 durch die jeweils zugeordneten Werte aus der Kurve 18 erhält man nun eine Schar von Punkten 20. Wie aus Fig. 4b zu erkennen, sind diese Punkte um einen Mittelwert 22 herum angeordnet, der ja in Schritt S16 berechnet wird.

Es kann zu einer Verzerrung in der Sinus-Form der Kurve kommen, sodass man anstelle einer fleckförmigen Gleichverteilung der Punkte eine ringförmige Verteilung erhält, wie in Fig. 5 gezeigt. Berechnet man hier den Mittelwert 22', so trifft dieser jedoch unabhängig von der Verzerrung der Sinus-Form ziemlich genau den gewünschten tatsächlichen Wert.

Während die Schritte S10 und S10' mit Hilfe von Messeinrichtungen des Diagnosegeräts D durchgeführt werden, werden die Messwerte in Form von Kleinsignalen einer Recheneinrichtung R im Diagnosegerät D zugeführt, in dem in Speicherplätzen die Messwerte abgespeichert werden. Mit Hilfe eines Zeigers (Pointers) können zwei Speicherplätze 24 und 26 oder 24' und 26' miteinander verkoppelt werden, um eine komplexe Zahl zu bilden, wie die Zahl $\underline{a}[k]$ oder $\underline{b}[k]$.

Die Recheneinrichtung R kann auch die weiteren Schritte des Bildens der Verhältnisgrößen in Schritt S14, des Bildens des Mittelwerts in Schritt S16 und die Berechnungsschritte S18, S20 und S22 durchführen.

Die Ausgabegrößen werden in Form von Kleinsignalen an einem Ausgang A oder auf einem Bildschirm B des Diagnosegeräts D ausgegeben.

Der Vorteil des erfindungsgemäßen Verfahrens wird klar ersichtlich, wenn man ihn mit dem eingangs geschilderten Verfahren von C. Freitag, I. Mladenovic und C. Weindl aus dem genannten Artikel "Fully Automated MV Cable Monitoring and Measurement System for Multi-Sample Acquisition of Artificial Agent Parameters" vergleicht. Diesen Artikel werden wir nachfolgend als Stand der Technik bezeichnen.

Vorliegend wurde ein Kurvenverlauf modelliert, nämlich zu einer Eingangsspannung (Kurve 110) und passend hierzu dem Strom (Kurve 112). Diese Eingangssignale sind als verrauscht und verzerrt modelliert. Es besteht eine Phasenverschiebung (Phasenwinkel) von 89,6 ° zwischen der Spannung und dem Strom.

Die Fig. 7 zeigt die komplexe Erweiterung, wie sie oben anhand der Fig. 3a und 3b erläutert wurde. Aus dem Vergleich von Fig. 4a und Fig. 7 wird ersichtlich, dass in diesem Beispiel Eingangssignale gewählt wurden, die starken Störeinflüssen unterliegen.

Geht man nun nach dem Stand der Technik vor, dann wird jede komplexe Zahl aus der Darstellung gemäß Fig. 7 mit einem Faktor $e^{-j\omega t}$ multipliziert, wobei j die imaginäre Einheit ist und $\omega$ die angenommene Frequenz der Sinusschwingung ist. t ist der Zeitpunkt der jeweiligen Messung.

Man transformiert somit in ein mit der Netzfrequenz rotierendes Koordinatensystem. Aufgrund des Rauschens und der Verzerrung erhält man eine Schar von einzelnen Punkten, die in Fig. 8a mit 124 bezeichnet ist, zur Spannung, und eine entsprechende Schar von einzelnen Punkten, die in Fig. 8a mit 126 bezeichnet ist, zum Strom. Beim Verfahren gemäß dem Stand der Technik wird nach dem Ermitteln dieser Schar von Punkten eine Filterung vorgenommen, sodass sich ein gefilterter Wert ergibt, der zur Spannung in Fig. 8a mit 128 bezeichnet ist und zum Strom in Fig. 8a mit 130 bezeichnet ist.

Diese gefilterten Werte werden dann durcheinander dividiert, sodass sich die in Fig. 8b gezeigte Impedanz gemäß dem Punkt 132 ergibt.

Geht man nun von denselben Eingangswerten aus, wie sie in Fig. 7 gezeigt sind, und führt das erfindungsgemäße Verfahren durch, wie oben erläutert, dann erhält man analog zu Fig. 4b eine in Fig. 9 gezeigte Schar von Punkten 120, jeweils unmittelbar zur Impedanz, und hierzu einen Mittelwert, entsprechend Punkt 122.

Zur Prüfung der Leistungsfähigkeit des erfindungsgemäßen Verfahrens im Vergleich zum Stand der Technik vergleichen wir den Zahlenwert, der zum Punkt 122 aus Fig. 9 gehört, mit dem Zahlenwert, der zum Punkt 132 aus Fig. 8b gehört.

Im Falle des Standes der Technik (Fig. 8b) lautet das Messergebnis, dass der Phasenwinkel zwischen Spannung und Strom 89,6338 ° beträgt. Die Abweichung zum tatsächlichen Wert (der aufgrund unserer Modellierung der Eingangswerte ja bekannt ist und 89,6 ° beträgt), beträgt 0,0338 °, dies sind 0,038 % des absoluten Wertes.

Hingegen ist das Messergebnis nach dem erfindungsgemäßen Verfahren, dass der Phasenwinkel 89,6019 ° beträgt. Der absolute Unterschied zum tatsächlichen Wert der Phasenverschiebung ist 0,0019 °, die prozentuale Abweichung beträgt 0,002 %.

Durch das erfindungsgemäße Verfahren wird daher eine um einen Faktor von ca. 20 höhere Genauigkeit beim Ermitteln der Phasenbeziehung zwischen Spannung und Strom erzielt.

Bezugszeichenliste

| | |
|---|---|
| P | Prüfling |
| D | Diagnosegerät |
| R | Recheneinrichtung |
| S10, S10', S12, S12', S14, S16, S18, S20, S22 | Schritte des erfindungsgemäßen Verfahrens |

| | |
|---|---|
| 10, 12, 16, 18, 110, 112 | Kurven |
| 14 | Kreis |
| 122, 124, 126, 130, 132 | Punkte |
| 20, 120, 124, 126 | Schar von Punkten |
| 22, 22' | Mittelwert |

**Patentansprüche**

1. Verfahren zum Ermitteln einer Beziehung zwischen einer sich im Wesentlichen gemäß einer Sinuskurve periodisch ändernden Spannung (a(t)) und einer sich im Wesentlichen gemäß einer Sinuskurve periodisch ändernden Stromstärke (b(t)), wobei die Spannung (a(t)) an einem Kabel anliegt und die Stromstärke (b(t)) eine Stromstärke eines durch die Isolation des Kabels fließenden Stroms ist, mit den Schritten:

   - Messen (S10) der Spannung (a(t)) zu einer Mehrzahl von Zeitpunkten $t_k$, k=1,...,N,
   - Messen (S10') der Stromstärke (b(t)) zu denselben Zeitpunkten $t_k$,
   - für jeden der Zeitpunkte $t_k$ Bilden (S12) eines 2-Tupels aus zwei zu unterschiedlichen Zeitpunkten gemessenen Werten der Spannung zur Angabe einer jeweiligen komplexen Zahl $\underline{a}[k]$,
   - für jeden der Zeitpunkte $t_k$ Bilden (S12') eines 2-Tupels aus zwei zu unterschiedlichen Zeitpunkten gemessenen Werten der Stromstärke zur Angabe einer jeweiligen komplexen Zahl $\underline{b}[k]$,

   wobei für jedes 2-Tupel für einen Zeitpunkt $t_k$ jeweils ein Messwert zum Zeitpunkt $t_k$ verwendet wird und ein Messwert zu einem Zeitpunkt $t_k'$ verwendet wird, der um $\frac{1}{4} \pm n,\ n \in \mathbb{Z}$ Periodendauern T der Sinuskurve zeitlich vom Zeitpunkt $t_k$ beabstandet ist, wobei der erste Eintrag des 2-Tupels als Realteil und der zweite Eintrag des 2-Tupels als Imaginärteil interpretiert wird,
   **gekennzeichnet durch**

   - Bilden (S14) der Verhältnisgröße $\underline{c}[k] = \frac{\underline{a}[k]}{\underline{b}[k]}$ für alle k,
   - aus allen Verhältnisgrößen $\underline{c}[k]$ unmittelbar Berechnen (S16) eines als 2-Tupel dargestellten Mittelwerts c nach einer mathematischen Rechenvorschrift,
   - Berechnen der Phase als Argument des Mittelwerts ($\varphi = \arg(\underline{c})$) und Berechnen des Betrags des Mittelwerts $|\underline{c}|$, wobei der erste Eintrag des 2-Tupels als Realteil und der zweite Eintrag des 2-Tupels als Imaginärteil interpretiert wird, und
   - Verwendung der Phase ($\varphi$) und des Betrags des Mittelwerts $|\underline{c}|$ als Aussage für die Beziehung zwischen Spannung und Stromstärke.

2. Verfahren nach Anspruch 1, bei dem das Kabel ein Mittel- oder Hochspannungskabel ist.

3. Verfahren nach einem der Ansprüche 1 oder 2, bei dem in den Schritten des Messens der Spannung und der Stromstärke gewonnene Messwerte einer Recheneinrichtung (R) zugeführt werden.

4. Verfahren nach Anspruch 3, bei dem die Recheneinrichtung (R) zum Bilden eines 2-Tupels jeweils einen ersten Speicherplatz (24, 24') für einen Messwert für die Größe mit einem zweiten Speicherplatz (26, 26') für einen anderen Messwert für die Größe verknüpft.

5. Verfahren nach Anspruch 4, bei dem im Schritte des Bildens der Verhältnisgröße Rechenschritte für eine Division komplexer Zahlen durchgeführt werden, wobei der jeweilige Messwert aus dem ersten Speicherplatz als Realteil und der jeweilige Messwert aus dem zweiten Speicherplatz als Imaginärteil interpretiert wird, sodass man als Verhältnisgröße wieder ein 2-Tupel erhält.

6. Verfahren nach Anspruch 5, bei dem im Schritt des Berechnens des Mittelwerts die 2-Tupel der Verhältnisgröße unter Verwendung der Rechenschritte einer Addition komplexer Zahlen zu einem neuen 2-Tupel verknüpft werden, wobei für die Addition der erste Eintrag des 2-Tupels ein Realteil und der zweite Eintrag des 2-Tupels als Imaginärteil interpretiert wird.

7. Verfahren nach einem der vorangehenden Ansprüche, bei dem aus zumindest einem von φ und $|\underline{c}|$ eine weitere Größe berechnet wird, insbesondere der Verlustfaktor tan (π/2 - φ), eine Impedanz, Admittanz, Resistanz, Konduktanz, der Leistungsfaktor cos φ, eine Dielektrizitätskonstante eines Kabels, eine Scheinleistung, Wirkleistung und/oder Blindleistung.

8. Verfahren nach einem der vorangehenden Ansprüche, bei dem der Mittelwert ein mit Hilfe einer Filterung berechneter gewichteter Mittelwert oder der arithmetische Mittelwert ist, $\underline{c} = \frac{1}{N} \sum_{k=1}^{N} \underline{c}[k]$ .

9. Verfahren nach einem der vorangehenden Ansprüche,
**dadurch gekennzeichnet,**
**dass** die Zeitpunkte $t_k$ in gleichen Abständen zum jeweils vorausgehenden bzw. nachfolgenden Zeitpunkt liegen.

10. Diagnosegerät (D) zum Ermitteln einer Beziehung zwischen einer Spannung und einer Stromstärke an einem Kabel mit:

- einer Einrichtung ($R_{Teiler}$) zum Messen der Spannung zu einer Mehrzahl von Zeitpunkten $t_k$, k = 1,..., N,
- einer Einrichtung ($R_{Shunt}$) zum Messen der Stromstärke zu denselben Zeitpunkten $t_k$,
- einer Recheneinrichtung (R), welche ausgelegt ist zum:

a) für jeden der Zeitpunkte $t_k$ Bilden eines 2-Tupels aus zwei zu unterschiedlichen Zeitpunkten $t_k$ gemessenen Werten der Spannung zur Angabe einer jeweiligen komplexen Zahl $\underline{a}[k]$, k = 1,...., N,
b) für jeden der Zeitpunkte $t_k$ Bilden eines 2-Tupels aus zwei zu denselben Zeitpunkten $t_k$ gemessenen Werten der Stromstärke zur Angabe einer jeweiligen komplexen Zahl $\underline{b}[k]$, k = 1,....., N,
wobei bei a) und b) für das 2-Tupel für einen Zeitpunkt $t_k$ jeweils ein Messwert zum Zeitpunkt $t_k$ verwendet wird und ein Messwert zu einem Zeitpunkt $t_{k'}$ verwendet wird, der um $\frac{1}{4} \pm n, \; n \in \mathbb{Z}$ Periodendauern T der Sinuskurve zeitlich vom Zeitpunkt $t_k$ beabstandet ist, wobei der erste Eintrag des 2-Tupels als Realteil und der zweite Eintrag des 2-Tupels als Imaginärteil interpretiert wird,
c) Bilden der Verhältnisgröße $\underline{c}[k] = \frac{\underline{a}[k]}{\underline{b}[k]}$ für alle k,
d) aus allen Verhältnisgrößen $\underline{c}[k]$ unmittelbar Berechnen (S16) eines als 2-Tupel dargestellten Mittelwerts $\underline{c}$ nach einer mathematischen Rechenvorschrift,
e) Berechnen der Phase als Argument des Mittelwerts (φ = arg ($\underline{c}$)) und Berechnen des Betrags des Mittelwerts $|\underline{c}|$, wobei der erste Eintrag des 2-Tupels als Realteil und der zweite Eintrag des 2-Tupels als Imaginärteil interpretiert wird, und
Verwendung der Phase (φ) und des Betrags des Mittelwerts $|\underline{c}|$ als Aussage für die Beziehung zwischen Spannung und Stromstärke.

11. Diagnosegerät nach Anspruch 10, das zur Durchführung des Verfahrens nach einem der Ansprüche 2 bis 9 ausgelegt ist.

## Claims

1. Method for determining a relationship between a voltage (a(t)) periodically changing substantially according to a sine curve and a current strength (b(t)) periodically changing substantially according to a sine curve, wherein the voltage (a(t)) is applied to a cable and the current strength (b(t)) is a current strength of a current flowing through the insulation of the cable, having the following steps:

- measuring (S10) the voltage (a(t)) at a multitude of points in time $t_k$, k =1,..., N,
- measuring (S10') the current strength (b(t)) at the same points in time $t_k$,

- for each of the points in time $t_k$, forming (S12) a 2-tuple from two values of the voltage measured at different points in time for specifying a respective complex number $\underline{a}[k]$,
- for each of the points in time $t_k$, forming (S12') a 2-tuple from two values of the current strength measured at different points in time for specifying a respective complex number $\underline{b}[k]$,

wherein, for each 2-tuple for a point in time $t_k$, in each case a measurement at the point in time $t_k$ is used, and a measurement at the point in time $t_{k'}$ is used which is spaced apart temporally from the point in time $t_k$ by $\frac{1}{4} \pm n, \quad n \in \mathbb{Z}$ period durations T of the sine curve, wherein the first entry of the 2-tuple is interpreted as the real part and the second entry of the 2-tuple as the imaginary part,

**characterised by**

- forming (S14) the ratio $\underline{c}[k] = \frac{\underline{a}[k]}{\underline{b}[k]}$ for all k,
- calculating (S16), directly from all ratios $\underline{c}[k]$, an average $\underline{c}$ depicted as a 2-tuple according to a mathematical calculation specification,
- calculating the phase as an argument of the average ($\varphi = \arg(\underline{c})$) and calculating the absolute value of the average $|\underline{c}|$, wherein the first entry of the 2-tuple is interpreted as the real part and the second entry of the 2-tuple as the imaginary part, and
- using the phase ($\varphi$) and the absolute value of the average $|\underline{c}|$ as an assertion for the relationship between voltage and current strength.

**2.** Method according to claim 1, in which the cable is a medium- or high-voltage cable.

**3.** Method according to one of claims 1 or 2, in which measurements obtained in the steps of measuring the voltage and the current strength are supplied to a computing device (R).

**4.** Method according to claim 3, in which the computing device (R), for forming a 2-tuple, respectively, links a first disk space (24, 24') for a measurement for the variable with a second disk space (26, 26') for a different measurement for the variable.

**5.** Method according to claim 4, in which, in the step of forming the ratio, calculation steps for a division of complex numbers are carried out, wherein the respective measurement from the first disk space is interpreted as the real part, and the respective measurement from the second disk space is interpreted as the imaginary part, such that a 2-tuple is again obtained as the ratio.

**6.** Method according to claim 5, in which, in the step of calculating the average, the 2-tuples of the ratio are linked to a new 2-tuple using the calculation steps of an addition of complex numbers, wherein, for the addition, the first entry of the 2-tuple is interpreted as the real part and the second entry of the 2-tuple as the imaginary part.

**7.** Method according to one of the preceding claims, in which a further variable is calculated from at least one of $\varphi$ and $|\underline{c}|$, in particular the loss factor $\tan(\pi/2 - \varphi)$, an impedance, admittance, resistance, conductance, the power factor $\cos \varphi$, a dielectricity constant of a cable, an apparent power, working power and/or blind power.

**8.** Method according to one of the preceding claims, in which the average is a weighted average calculated by means of a filter or is the arithmetic average $\underline{c} = \frac{1}{N} \sum_{k=1}^{N} \underline{c}[k]$ .

**9.** Method according to one of the preceding claims,
**characterised in that**
the points in time $t_k$ are at equal spacings in relation to the respectively preceding or succeeding point in time.

**10.** Diagnostic device (D) for determining a relationship between a voltage and a current strength on a cable, having:

- a device ($R_{Teiler}$) for measuring the voltage at a multitude of points in time $t_k$, k = 1,...,N,

- a device ($R_{Shunt}$) for measuring the current strength at the same points in time $t_k$,
- a computing device (R), which is designed to:

a) form a 2-tuple from two values of the voltage measured at different points in time $t_k$ for each of the points in time $t_k$ for specifying a respective complex number $\underline{a}[k]$, k = 1,..., N,
b) form a 2-tuple from two values of the current strength measured at the same points in time $t_k$ for each of the points in time $t_k$ for specifying a respective complex number $\underline{b}[k]$, k = 1,..., N,
wherein, with a) and b), for the 2-tuple for a point in time $t_k$ in each case a measurement at the point in time $t_k$ is used and a measurement at a point in time $t_{k'}$ is used, which is spaced apart temporally from the point in time $t_k$ by $\frac{1}{4} \pm n, \; n \in \mathbb{Z}$ period durations T of the sine curve, wherein the first entry of the 2-tuple is interpreted as the real part and the second entry of the 2-tuple as the imaginary part,
c) forming the ratio $\underline{c}[k] = \frac{\underline{a}[k]}{\underline{b}[k]}$ for all k,
d) calculating (S16), directly from all ratios $\underline{c}[k]$, an average $\underline{c}$ depicted as a 2-tuple according to a mathematical calculation specification,
e) calculating the phase as an argument of the average ($\varphi = \arg(\underline{c})$) and calculating the absolute value of the average |c|, wherein the first entry of the 2-tuple is interpreted as the real part and the second entry of the 2-tuple as the imaginary part, and
using the phase ($\varphi$) and the absolute value of the average $|\underline{c}|$ as an assertion for the relationship between voltage and current strength.

**11.** Diagnostic device according to claim 10, which is designed to carry out the method according to one of claims 2 to 9.

## Revendications

**1.** Procédé de détermination d'une relation entre une tension (a(t)) variant périodiquement essentiellement selon une courbe sinusoïdale et une intensité (b(t)) variant périodiquement essentiellement selon une courbe sinusoïdale, dans lequel la tension (a(t)) est appliquée à un câble et l'intensité (b(t)) est une intensité d'un courant traversant l'isolation du câble, avec les étapes suivantes :

- mesurer (S10) la tension (a(t)) à une pluralité de moments $t_k$, k= 1, ..., N,
- mesurer (S10') l'intensité (b(t)) aux mêmes moments $t_k$,
- pour chacun des moments $t_k$, formation (S12) d'un 2-uplet constitué de deux valeurs de la tension mesurée à des moments différents, afin d'obtenir un nombre complexe $\underline{a}[k]$ correspondant,
- pour chacun des moments $t_k$, formation (S12') d'un 2-uplet constitué de deux valeurs de l'intensité mesurée à des moments différents, afin d'obtenir un nombre complexe $\underline{b}[k]$ correspondant,
dans lequel, pour chaque 2-uplet pour un moment $t_k$, une valeur de mesure au moment $t_k$ est utilisée et une valeur de mesure à un moment $t_k$' est utilisée, qui est éloigné temporellement de $\frac{1}{4} \pm n, \; n \in \mathbb{Z}$ périodes T de la courbe sinusoïdale du moment $t_k$, la première entrée du 2-uplet étant interprétée comme une partie réelle et la deuxième entrée du 2-uplet étant interprétée comme une partie imaginaire,
**caractérisé par**
- la formation (S14) de la grandeur de rapport $\underline{c}[k] = \frac{\underline{a}[k]}{\underline{b}[k]}$ pour tout k,
- à partir de toutes les grandeurs de rapport $\underline{c}[k]$, calcul direct (S16) d'une valeur moyenne $\underline{c}$, représentée comme un 2-uplet, selon une règle de calcul mathématique,
- calculer la phase en tant qu'argument de la valeur moyenne ($\varphi = \arg(\underline{c})$) et calcul de la valeur absolue de la moyenne $|\underline{c}|$, la première entrée du 2-uplet étant interprétée comme une partie réelle et la deuxième entrée du 2-uplet étant interprétée comme une partie imaginaire, et
- utiliser de la phase ($\varphi$) et la valeur absolue de la moyenne $|\underline{c}|$ en tant qu'assertion pour la relation entre la tension et l'intensité.

2. Procédé selon la revendication 1, dans lequel le câble est un câble à moyenne ou haute tension.

3. Procédé selon l'une des revendications 1 ou 2, dans lequel, dans les étapes de mesure de la tension et de l'intensité, les valeurs de mesure obtenues sont entrées dans un dispositif de calcul (R).

4. Procédé selon la revendication 3, dans lequel le dispositif de calcul (R) combine, pour la formation d'un 2-uplet, respectivement, un premier emplacement de mémoire (24, 24') pour une valeur de mesure pour la grandeur avec un deuxième emplacement de mémoire (26, 26') pour une autre valeur de mesure pour la grandeur.

5. Procédé selon la revendication 4, dans lequel, dans l'étape de formation de la grandeur de rapport, des étapes de calcul pour une division de nombres complexes sont exécutées, la valeur de mesure correspondante provenant du premier emplacement de mémoire étant interprétée comme une partie réelle et la valeur de mesure correspondante provenant du deuxième emplacement de mémoire étant interprétée comme une partie imaginaire, de façon à obtenir, en tant que grandeur de rapport, à nouveau un 2-uplet.

6. Procédé selon la revendication 5, dans lequel, dans l'étape de calcul de la valeur moyenne, les 2-uplets de la grandeur de rapport sont combinés, à l'aide des étapes de calcul d'une addition de nombres complexes, en un nouveau 2-uplets, moyennant quoi, pour l'addition, la première entrée du 2-uplet étant interprétée comme une partie réelle et la deuxième entrée du 2-uplet étant interprétée comme une partie imaginaire.

7. Procédé selon l'une des revendications précédentes, dans lequel, à partir d'au moins un parmi $\varphi$ et $|\underline{c}|$, une autre grandeur est calculée, plus particulièrement le facteur de perte tan ($\pi/2$ - $\varphi$), une impédance, une admittance, une résistance, une conductance, le facteur de puissance cos $\varphi$, une constante diélectrique d'un câble, une puissance apparente, une puissance active et/ou une puissance réactive.

8. Procédé selon l'une des revendications précédentes, dans lequel la valeur moyenne est une valeur moyenne pondérée calculée à l'aide d'un filtrage ou la valeur moyenne arithmétique est $\underline{c} = \frac{1}{N} \sum_{k=1}^{N} \underline{c}[k]$ .

9. Procédé selon l'une des revendications précédentes,
**caractérisé en ce que**
les moments $t_k$ se trouvent à distances égales par rapport au moment précédent ou au moment suivant.

10. Appareil de diagnostic (D) pour la détermination d'une relation entre une tension et une intensité au niveau d'un câble, avec :

- un dispositif ($R_{Teiler}$) pour la mesure de la tension à une pluralité de moments $t_k$, k = 1, ..., N,
- un dispositif ($R_{Shunt}$) pour la mesure de l'intensité aux même moments $t_k$,
- un dispositif de calcul (R) qui est conçu pour

a) la formation, pour chacun des moments $t_k$, d'un 2-uplet constitué de deux valeurs, mesurées aux mêmes moments $t_k$, de la tension, afin d'obtenir un nombre complexe $\underline{a}[k]$, k = 1, ..., N,
b) la formation, pour chacun des moments $t_k$, d'un 2-uplet constitué de deux valeurs, mesurées à des moments $t_k$ différents, de l'intensité, afin d'obtenir un nombre complexe $\underline{b}[k]$, k = 1, ..., N,
dans lequel, dans a) et b), pour le 2-uplet pour un moment $t_k$, respectivement, une valeur de mesure au moment $t_k$ est utilisée et une valeur de mesure à un moment tk' est utilisée, qui est éloigné temporellement de $\frac{1}{4} \pm n,\ n \in \mathbb{Z}$ périodes T de la courbe sinusoïdale du moment $t_k$, la première entrée du 2-uplet étant interprétée comme une partie réelle et la deuxième entrée du 2-uplet étant interprétée comme une partie imaginaire,

c) la formation de la grandeur de rapport $\underline{c}[k]=\frac{\underline{a}[k]}{\underline{b}[k]}$ pour tout k,

d) à partir de toutes les grandeurs de rapport $\underline{c}[k]$, calcul direct (S16) d'une valeur moyenne $\underline{c}$, représentée comme un 2-uplet, selon une règle de calcul mathématique,

e) le calcul de la phase en tant qu'argument de la valeur moyenne ($\varphi = \arg(\underline{c})$) et calcul de la valeur absolue de la moyenne $|\underline{c}|$, la première entrée du 2-uplet étant interprétée comme une partie réelle et la deuxième entrée du 2-uplet étant interprétée comme une partie imaginaire, et

l'utilisation de la phase ($\varphi$) et de la valeur absolue de la moyenne $|\underline{c}|$ en tant qu'assertion pour la relation entre la tension et l'intensité.

**11.** Appareil de diagnostic selon la revendication 10, qui est conçu pour l'exécution du procédé selon l'une des revendications 2 à 9.

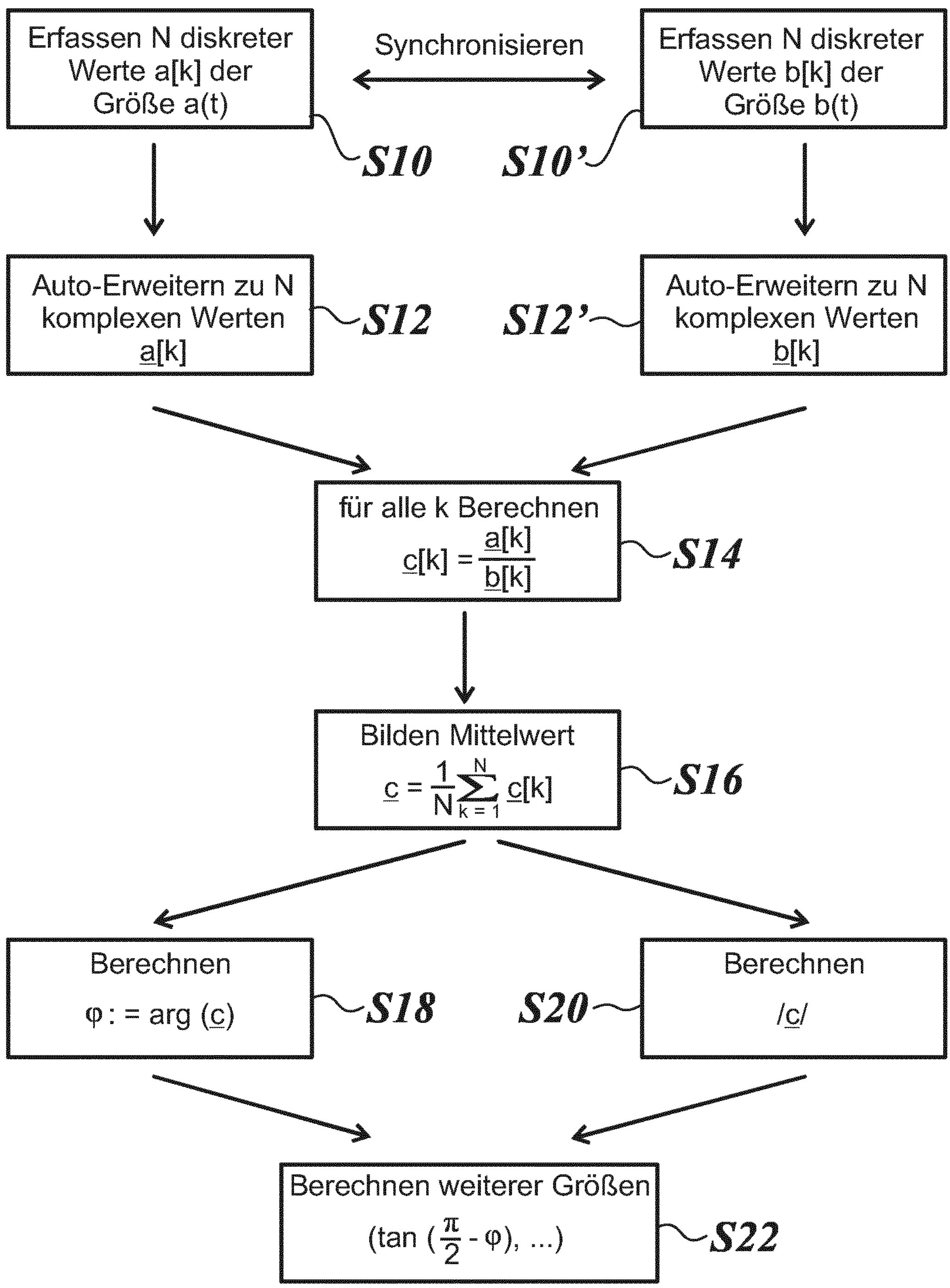
Erfassen N diskreter Werte a[k] der Größe a(t)
Synchronisieren
Erfassen N diskreter Werte b[k] der Größe b(t)
S10
S10'
Auto-Erweitern zu N komplexen Werten a[k]
S12
S12'
Auto-Erweitern zu N komplexen Werten b[k]
für alle k Berechnen c[k] = a[k] / b[k]
S14
Bilden Mittelwert c = 1/N Σ c[k] (k = 1 … N)
S16
Berechnen φ: = arg (c)
S18
S20
Berechnen /c/
Berechnen weiterer Größen (tan (π/2 - φ), ...)
S22

*Fig. 1*

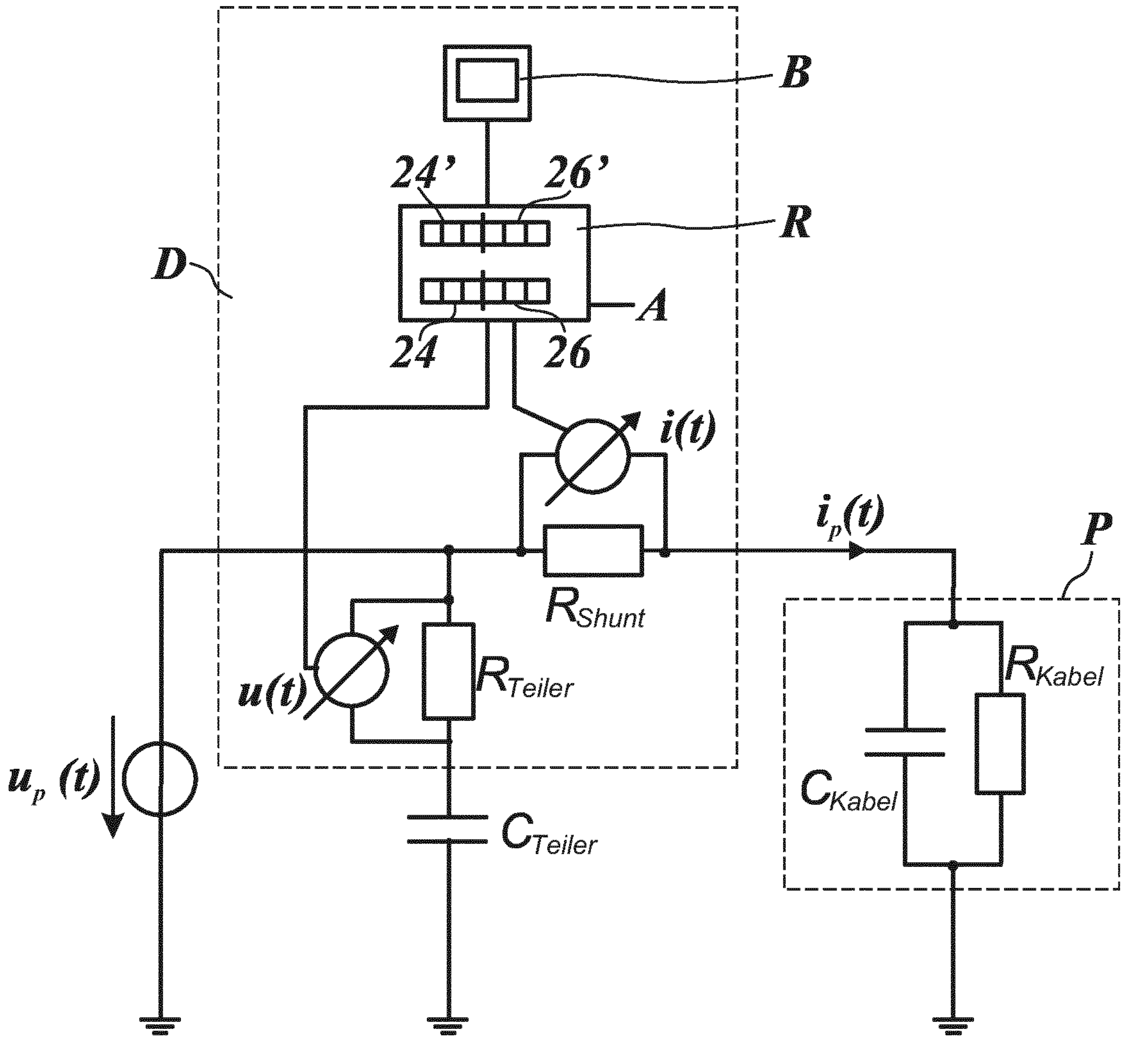
B
24'
26'
R
D
A
24
26
i(t)
$i_p(t)$
P
$R_{Shunt}$
$R_{Kabel}$
u(t)
$R_{Teiler}$
$u_p\ (t)$
$C_{Kabel}$
$C_{Teiler}$

Fig. 2a

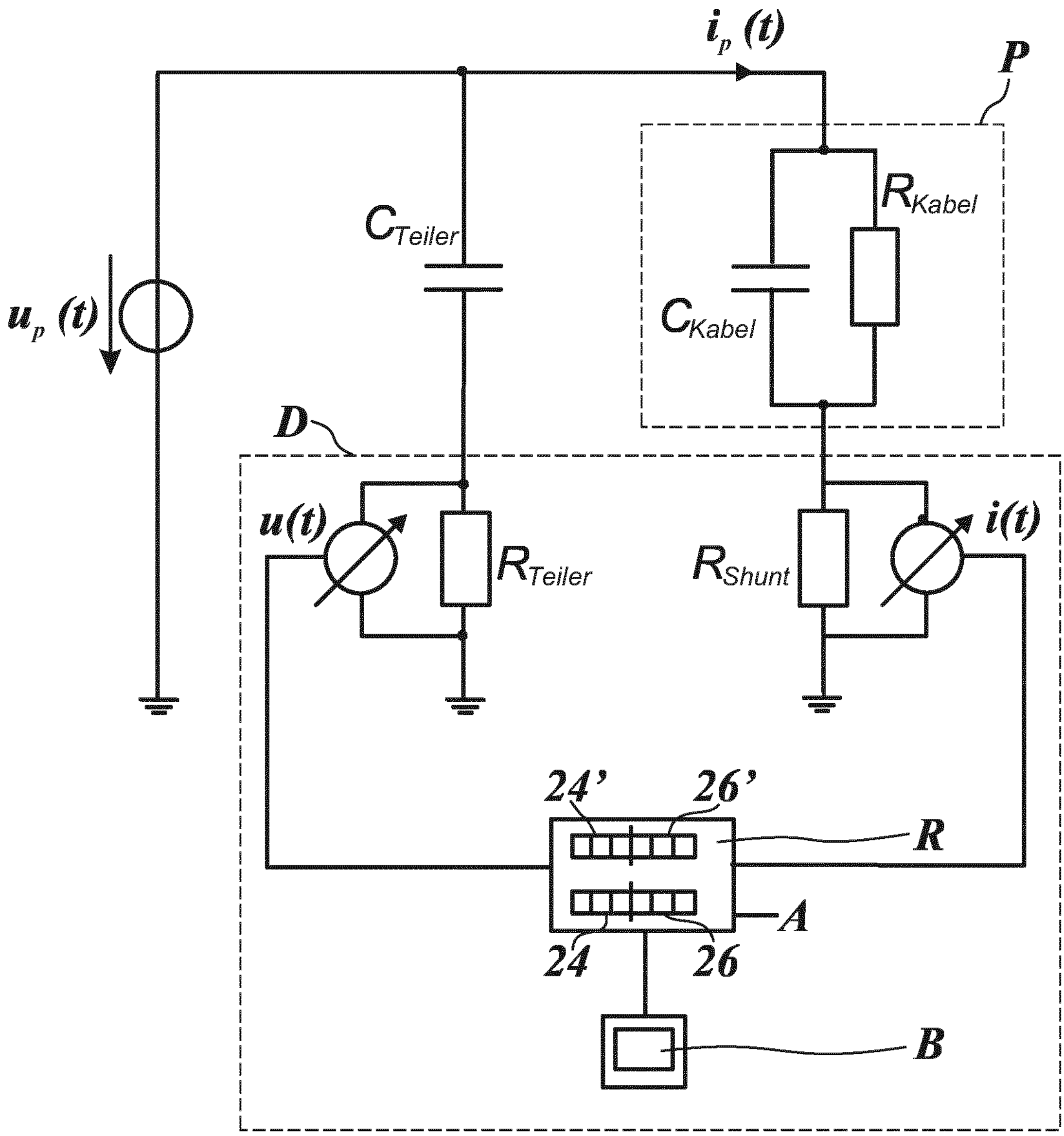
i_p (t)
P
R_Kabel
C_Teiler
C_Kabel
u_p (t)
D
u(t)
R_Teiler
R_Shunt
i(t)
24'
26'
R
A
24
26
B

Fig. 2b

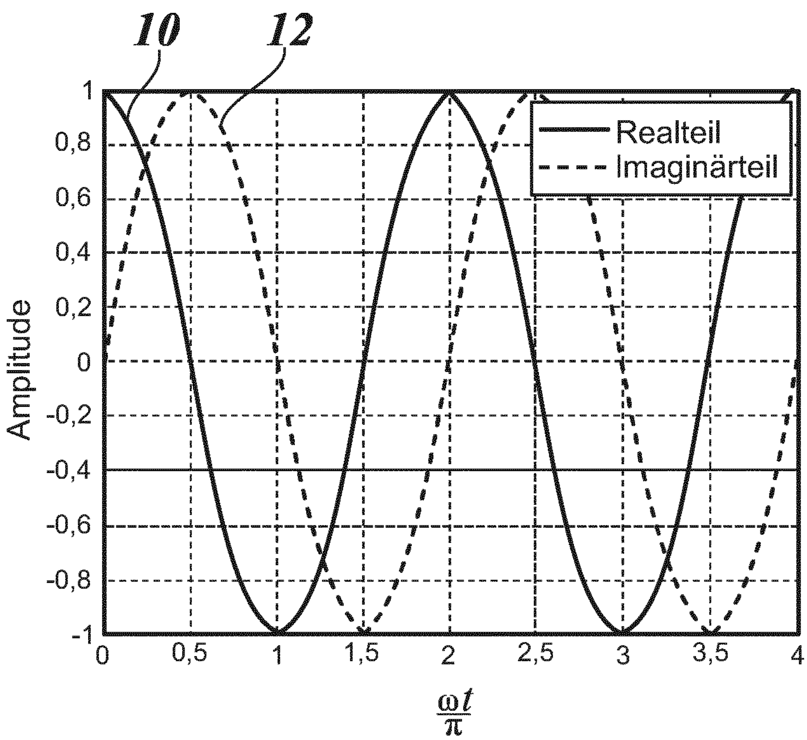
10
12
1
0,8
0,6
0,4
0,2
0
-0,2
-0,4
-0,6
-0,8
-1
Amplitude
0
0,5
1
1,5
2
2,5
3
3,5
4
Realteil
Imaginärteil
ωt/π

*Fig. 3a*

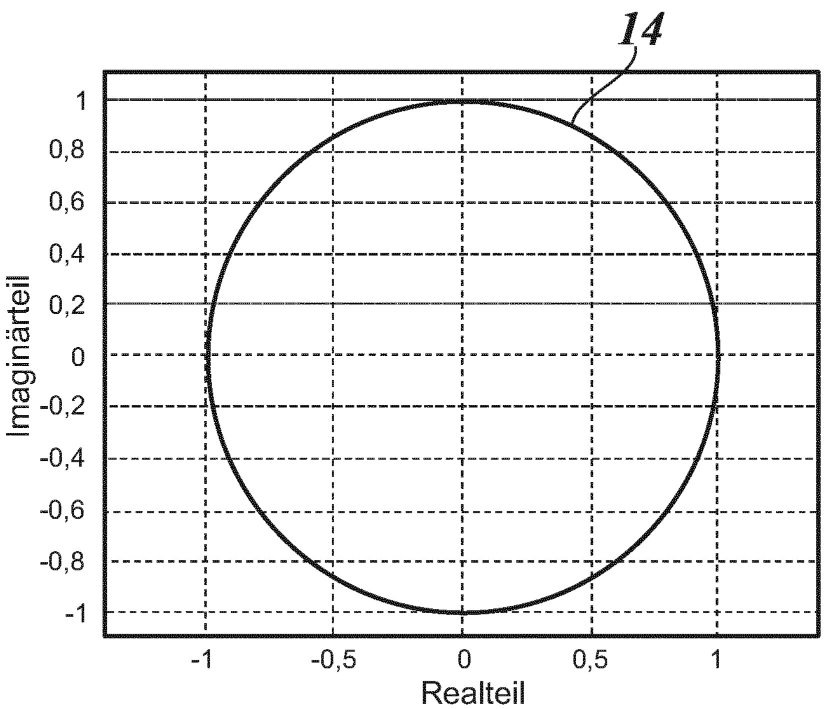
14
1
0,8
0,6
0,4
0,2
0
-0,2
-0,4
-0,6
-0,8
-1
Imaginärteil
-1
-0,5
0
0,5
1
Realteil

*Fig. 3b*

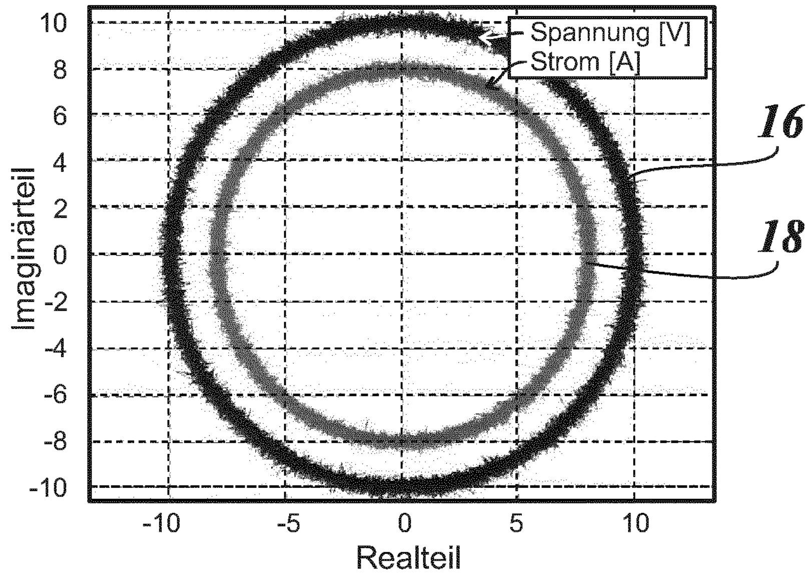
10
8
6
4
2
0
-2
-4
-6
-8
-10
Imaginärteil
-10
-5
0
5
10
Realteil
Spannung [V]
Strom [A]
16
18

*Fig. 4a*

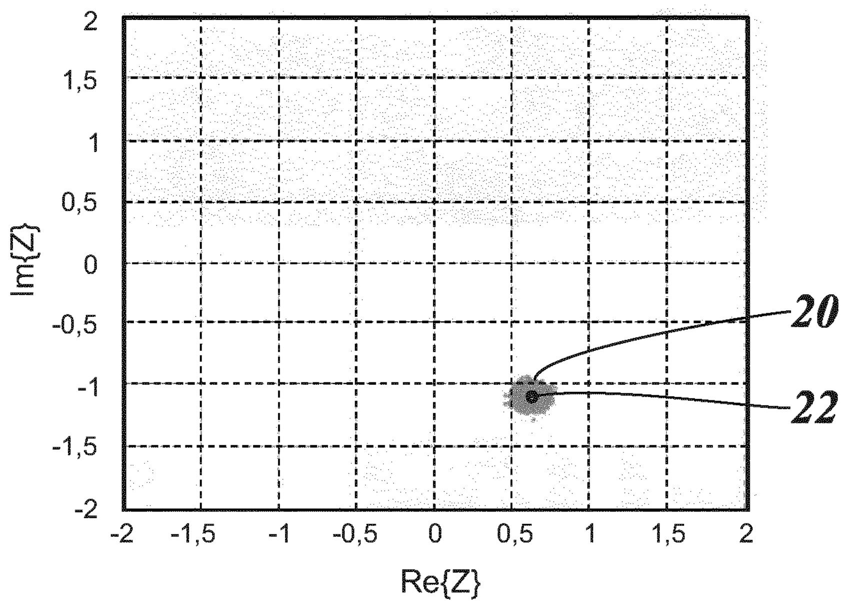
2
1,5
1
0,5
0
-0,5
-1
-1,5
-2
Im{Z}
-2
-1,5
-1
-0,5
0
0,5
1
1,5
2
Re{Z}
20
22

*Fig. 4b*

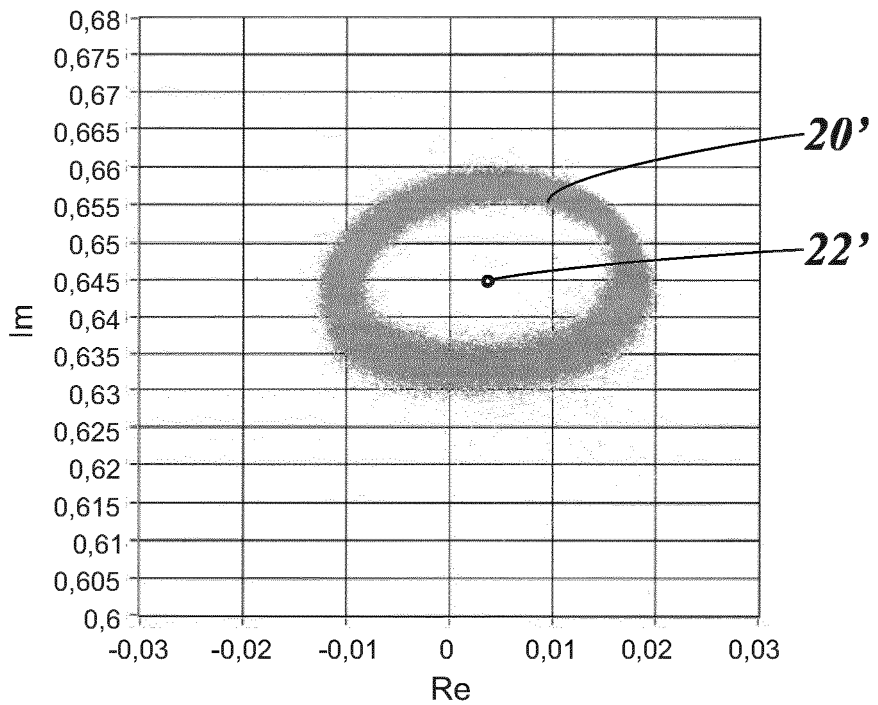
0,68
0,675
0,67
0,665
0,66
0,655
0,65
0,645
0,64
0,635
0,63
0,625
0,62
0,615
0,61
0,605
0,6
Im
-0,03
-0,02
-0,01
0
0,01
0,02
0,03
Re
20'
22'

*Fig. 5*

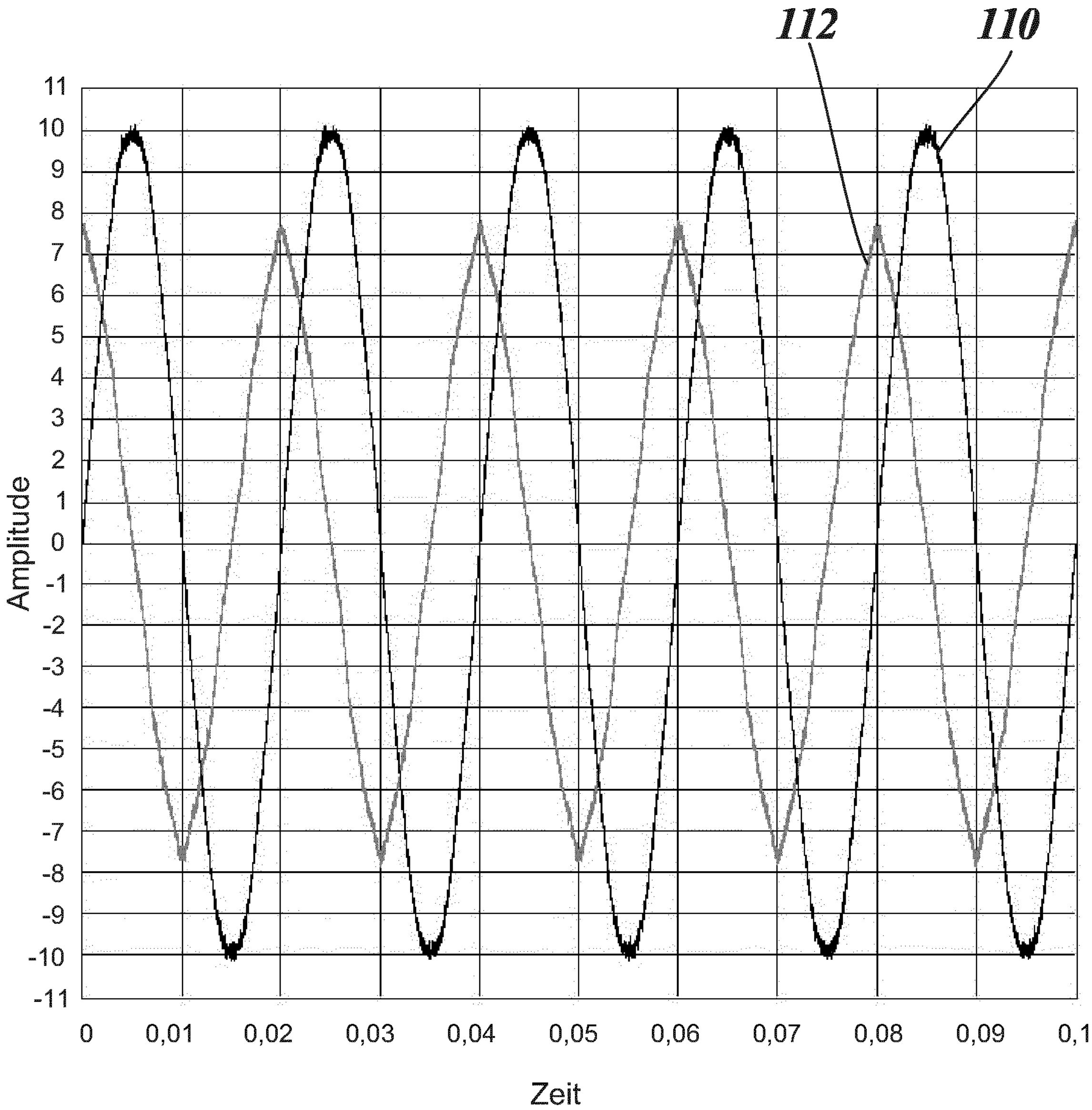
112
110
11
10
9
8
7
6
5
4
3
2
1
0
-1
-2
-3
-4
-5
-6
-7
-8
-9
-10
-11
Amplitude
0
0,01
0,02
0,03
0,04
0,05
0,06
0,07
0,08
0,09
0,1
Zeit

*Fig. 6*

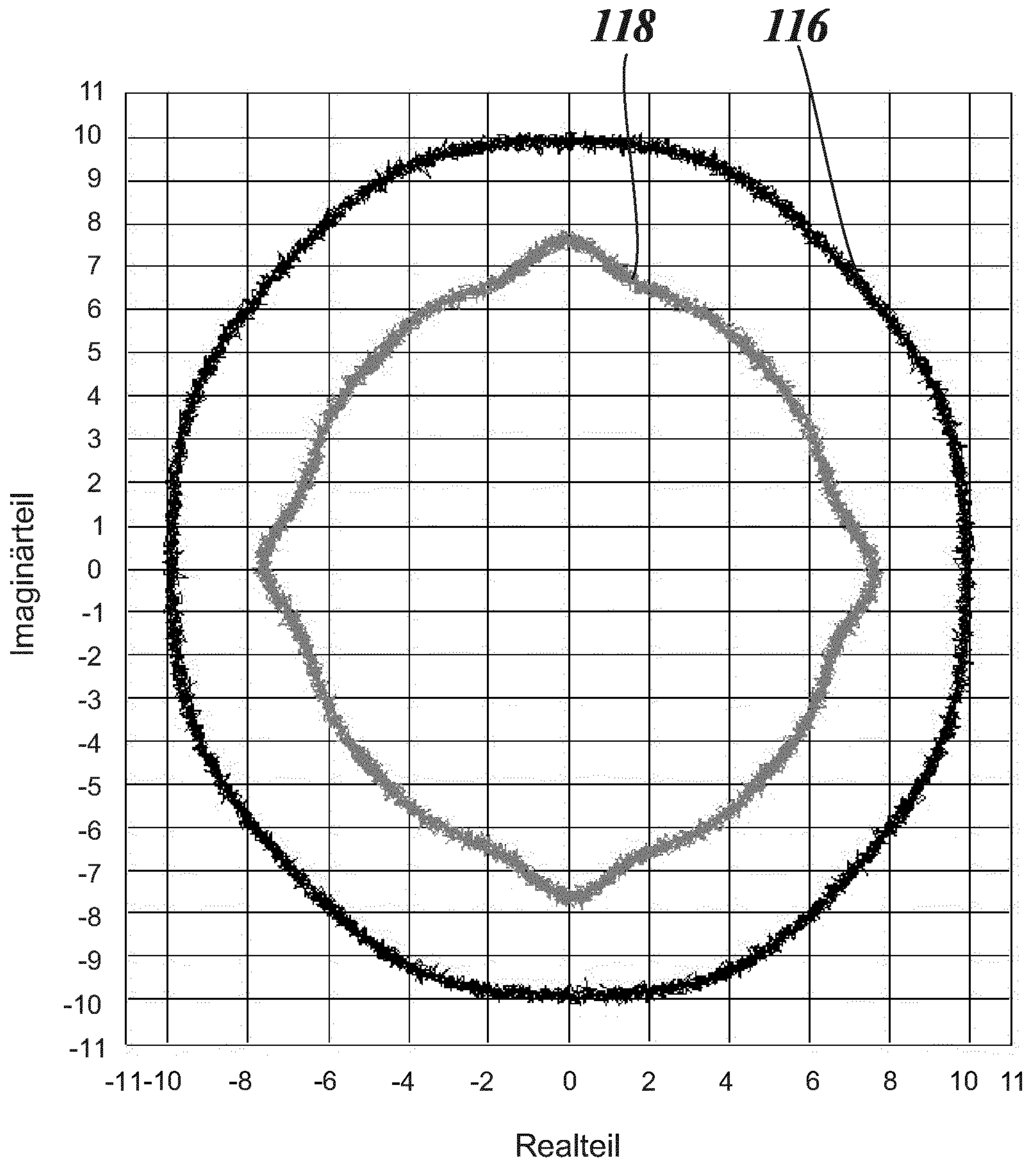
118
116
Imaginärteil
11
10
9
8
7
6
5
4
3
2
1
0
-1
-2
-3
-4
-5
-6
-7
-8
-9
-10
-11
-11-10 -8 -6 -4 -2 0 2 4 6 8 10 11
Realteil

*Fig. 7*

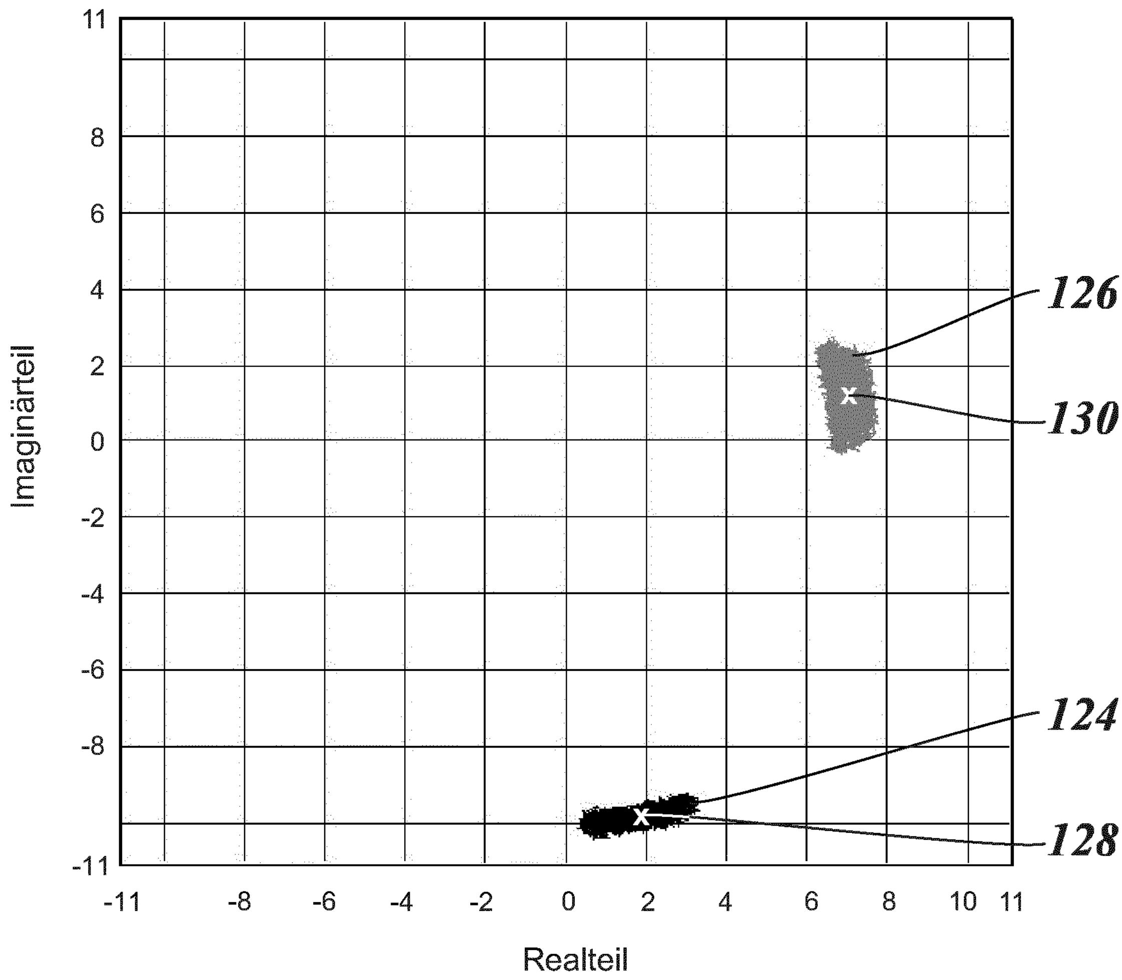
11
8
6
4
2
0
-2
-4
-6
-8
-11
Imaginärteil
-11
-8
-6
-4
-2
0
2
4
6
8
10
11
Realteil
126
130
124
128

Fig. 8a

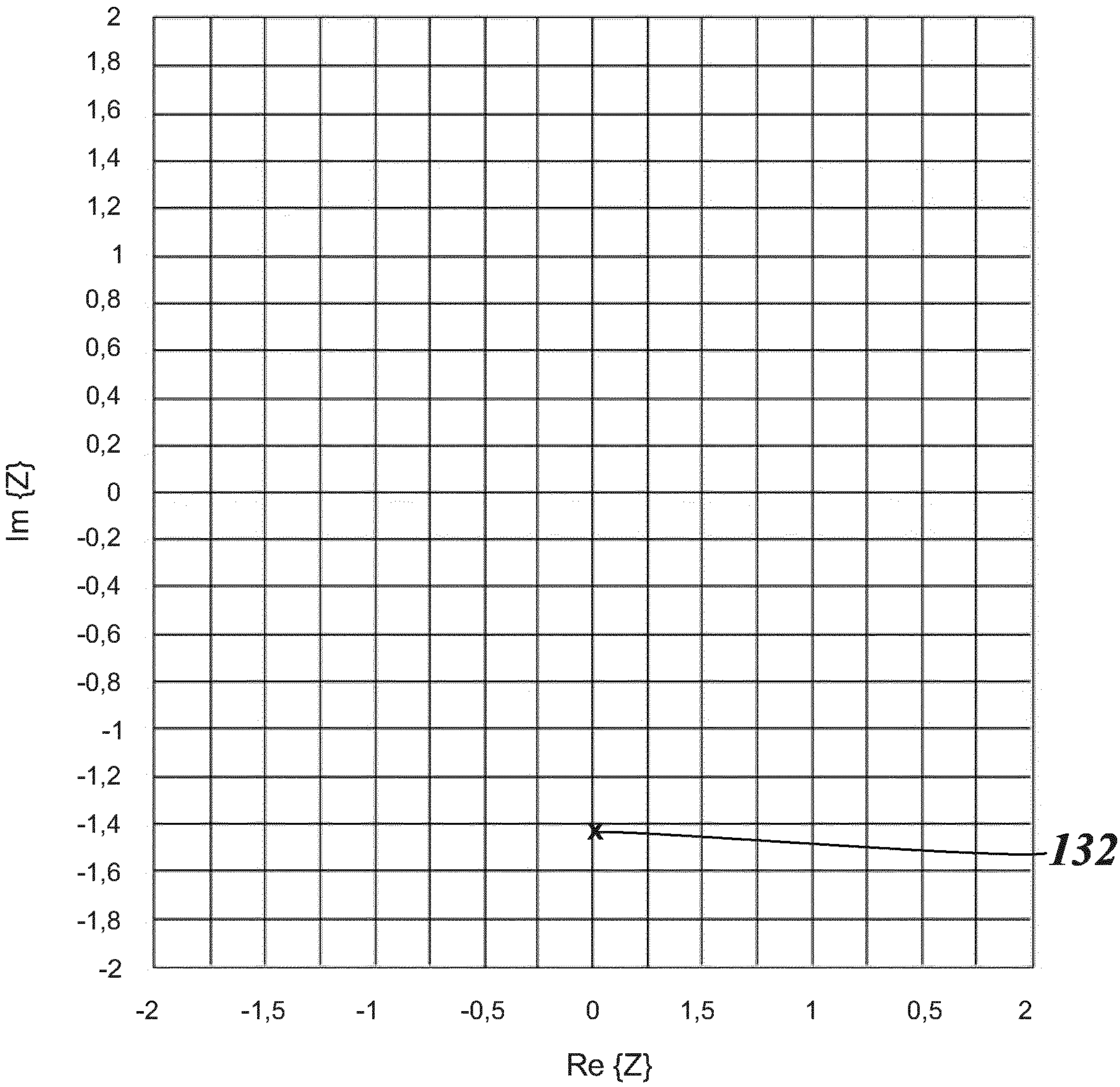
2
1,8
1,6
1,4
1,2
1
0,8
0,6
0,4
0,2
0
-0,2
-0,4
-0,6
-0,8
-1
-1,2
-1,4
-1,6
-1,8
-2
Im {Z}
-2
-1,5
-1
-0,5
0
1,5
1
0,5
2
Re {Z}
132

Fig. 8b

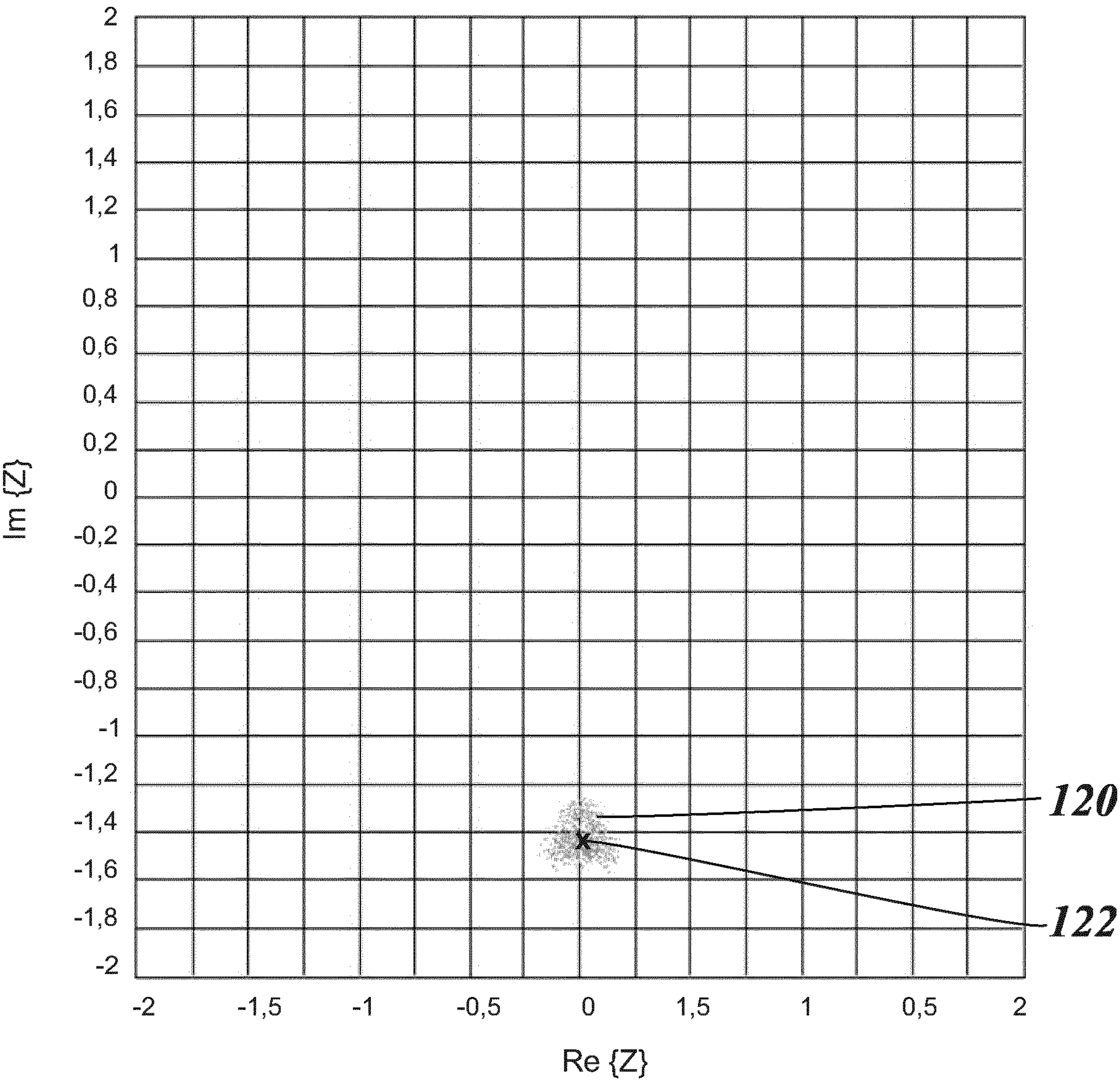
2
1,8
1,6
1,4
1,2
1
0,8
0,6
0,4
0,2
0
-0,2
-0,4
-0,6
-0,8
-1
-1,2
-1,4
-1,6
-1,8
-2
Im {Z}
-2
-1,5
-1
-0,5
0
1,5
1
0,5
2
Re {Z}
120
122

*Fig. 9*

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Nicht-Patentliteratur


- **C. FREITAG ; I. MLADENOVIC ; C. WEINDL.** Fully Automated MV Cable Monitoring and Measurement System for Multi-Sample Acquisition of Artificial Aging Parameters. *International Conference on Renewable Energies and Power Quality (ICREPQ'10,* 25. Marz 2010
- **M.SZYPER.** Spectral analysis of nonstationary signals in the system with wide phase modulation. *Proceedings of the IEEE Instrumentation and Measurement Technology Conference,* 14. Mai 1992, 42-45